# EUROPEAN PATENT APPLICATION

(11) **EP 1 100 117 A2**
(43) Date of publication of application: **16.05.2001**
(21) Application number: 00124226.2
(22) Date of filing: 09.11.2000
(51) Int. Cl.: H01L 21/3065

(54) **A surface treatment method for a silicon wafer**

(30) Priority: 11.11.1999 JP 32089299
(71) Applicant: SPEEDFAM CO.,LTD., Kanagawa-ken, 252-1123 (JP)
(72) Inventor: Yanagisawa, Michihiko, Sagamihara-city, Kanagawa-pref. 228-0824 (JP); Sadohara, Takeshi, Ayase-city, Kanagawa-pref. 252-1105 (JP)
(74) Representative: HOFFMANN - EITLE

(57) **Abstract**

A surface of a silicon wafer is etched and flattened by injecting a plasma-excited active fluorine species gas of fluoride, e.g. SF6 on the surface of the silicon wafer. During the surface being etched, a sulfur or sulfur compound is separated from the species gas and absorbed on the surface of the silicon wafer. The separated or absorbed material is removed from the surface and thin layer of a silicon oxide is formed thereon by exposing the silicon wafer to a plasma-excited active oxygen species gas or by dipping the silicon wafer into ozone water or hydrofluoric acid solution.

## Description

### BACKGROUND OF THE INVENTION

### 1. Field of the Invention

The present invention relates to a method for removing contaminants from a surface of a silicon wafer after planarization and forming a layer of silicon oxide on the wafer surface.

### 2. Description of the Related Art

For highly flattening a surface of a silicon wafer there is used a lapping machine, a chemomechanical polishing (CMP) apparatus, or a local dry etching apparatus.

The CMP apparatus is for polishing a surface of a silicon wafer mechanically and chemically, and the local dry etching apparatus is for locally etching a surface of a silicon wafer with use of an active fluorine species gas from plasma-excitation of a fluoride. Recently, to meet the demand for a higher semiconductor density there has been used a local etching apparatus which can afford a higher flatness.

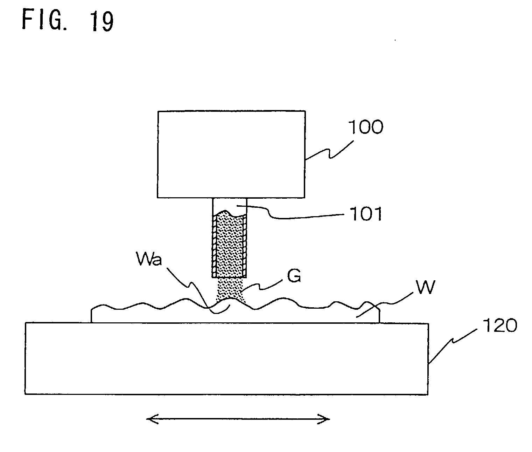

Fig. 19 shows a commonly-used local etching apparatus schematically.

In the local etching apparatus, sulfur hexafluoride (SF₆) gas, tetrafluoromethane (CF₄) gas, or hexafluoroethane (C₂F₆) gas is plasma-excited in a plasma generator 100 and the thus excited gas (an active fluorine species gas) G is injected through a nozzle 101 onto a surface Wa of a silicon wafer W placed on a chuck 120.

When a thick portion of the silicon wafer W is to be etched, the nozzle 101 is moved at a lower speed (a relative speed along the surface Wa of the silicon wafer W) than when etching a thin portion of the wafer, whereby at the thick portion the active fluorine species gas G is injected for a longer time to remove a larger amount of material. Thus, by controlling the said relative speed it is possible to flatten the silicon wafer surface.

In this local etching apparatus, a portion of the active fluorine species gas used undergoes a chemical change and there is produced sulfur, carbon, or a compound thereof. This product is deposited on a surface of the silicon wafer and causes contamination of a cleaning vessel in a subsequent cleaning process or contamination of a cassette which is for receiving the silicon wafer therein.

Further, since the flattened surface of the silicon wafer, which surface is a virgin surface, is activated very strongly, the wafer surface silicon easily undergoes a chemical reaction with impurities present in air. In Japanese Published Unexamined Patent Application No. Hei 10-135161 is disclosed a method wherein, for preventing a silicon wafer surface flattened by mechanical lapping from undergoing a chemical reaction with impurities present in air, a layer of silicon oxide is formed on the wafer surface with use of ozone water, aqueous hydrogen peroxide, aqueous sulfuric acid solution, or an aqueous nitric acid solution.

However, this method is not satisfactory because there occurs a chemical reaction between the silicon wafer surface and impurities present in air due to contact of the wafer surface with air during the period after planarization of the wafer until formation of a silicon oxide layer on the wafer surface. Besides, this method is not intended to remove a separated material which is a simple substance or a compound of sulfur or carbon and which has been deposited on the wafer surface by local etching.

### SUMMARY OF THE INVENTION

It is an object of the present invention to provide a novel surface treatment method for a silicon wafer.

It is another object of the present invention to provide a novel surface treatment method for removing sulfur, carbon, or a compound thereof deposited on a surface of a silicon wafer.

It is a further object of the present invention to provide a novel surface treatment method for removing sulfur, carbon, or a compound thereof deposited on a surface of a silicon wafer and forming a layer of silicon oxide on the wafer surface.

It is a still further object of the present invention to provide a novel surface treatment method for removing sulfur, carbon, or a compound thereof deposited on a surface of a silicon wafer and forming a layer of silicon oxide on the wafer surface without contact with air.

It is a still further object of the present invention to provide a method for removing, from a surface of a silicon wafer, sulfur, carbon, or a compound thereof which have been produced by local etching at the time of flattening the silicon wafer surface and deposited on the wafer surface, and for preventing the wafer surface from newly contaminated by impurities present in air.

One surface treatment method for a silicon wafer according to the present invention includes the step of injecting a plasma-excited active fluorine species gas of fluoride onto a surface of a silicon wafer to etch the wafer surface. In this step, a separated material having been separated from the plasma-excited active fluorine species gas and deposited on the wafer surface is removed from the wafer surface by exposure of the same surface to a plasma-excited active oxygen species gas.

Another surface treatment method for a silicon wafer according to the present invention includes the step of injecting a plasma-excited active fluorine species gas fluoride onto a surface of a silicon wafer to etch the wafer surface. In this step, a separated material having been separated from the plasma-excited active fluorine species gas and deposited on the silicon wafer surface, which separated material is a simple substance of sulfur or a sulfur compound, is removed by dipping the wafer into ozone water or a hydrofluoric acid solution.

The above and other objects, features and advantages of the present invention will more readily be understood by those skilled in the art from the following detailed description of the invention when read in conjunction with the accompanying drawings.

### BRIEF DESCRIPTION OF THE DRAWINGS

Fig. 1 is a sectional view showing schematically a planarizing system according to the first embodiment of the present invention;
Fig. 2 is a sectional view showing a chuck 2 used in the planarizing system shown in Fig. 1;
Fig. 3 is a plan view of the chuck shown in Fig. 2;
Fig. 4 is a sectional view showing a chuck support in an X-Y drive mechanism;
Fig. 5 is a plan view of the chuck support shown in Fig. 4;
Fig. 6 is aplanviewof a silicon wafer, showing a scanning path of a nozzle portion with respect to the silicon wafer;
Fig. 7 is a schematic diagram for explaining the principle of flattening a surface Wa of a silicon wafer W;
Fig. 8 is a sectional view showing a planarizing system according to the second embodiment of the present invention;
Fig. 9 is a schematic plan view of the planarizing system of the second embodiment;
Fig. 10 is a plan view showing the structure of a chuck 2' used in the second embodiment;
Fig. 11 is a sectional view thereof;
Fig. 12 is a perspective view showing a wafer cassette used in the second embodiment;
Fig. 13 is a sectional view with a hand inserted below a silicon wafer in the second embodiment;
Fig. 14 is a sectional view with the silicon wafer taken out by the hand in the second embodiment;
Fig. 15 is a sectional view showing a planarizing system for a silicon wafer according to the third embodiment of the present invention;
Fig. 16 is a schematic sectional view showing a modification of the third embodiment;
Fig. 17 is a schematic plan view showing a multi-chamber type planarizing system;
Fig. 18 is a sectional view showing a modification of the chuck 2 for holding a silicon wafer W; and
Fig. 19 is a sectional view showing a conventional local dry etching apparatus schematically.

### DESCRIPTION OF THE PREFERRED EMBODIMENTS

Now, preferred embodiments of the present invention will be described in detail while referring to the accompanying drawings.

### FIRST EMBODIMENT

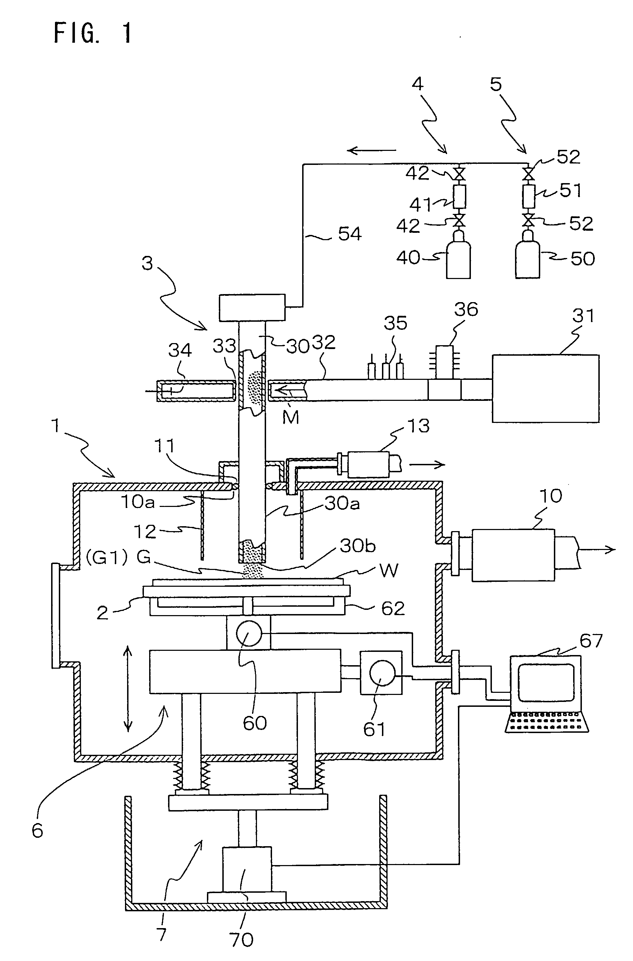

Fig. 1 is a sectional view showing a planarizing system according to the first embodiment of the present invention.

The planarizing system of this embodiment is provided with a chamber 1, a chuck 2, a plasma generator 3, a local etching gas feeder 4, an oxygen gas feeder 5, an X-Y drive mechanism for moving the chuck 2 in a horizontal plane, and a Z drive mechanism for moving the chuck 2 in the vertical direction.

The chamber 1 is in the shape of a box within which a silicon wafer W is to be processed. The interior of the chamber 1 can be made substantially vacuous by means of a vacuum pump 10.

The chuck 2 is disposed within the chamber 1 and functions to attract the back of the silicon wafer W electrostatically and hold the wafer thereby.

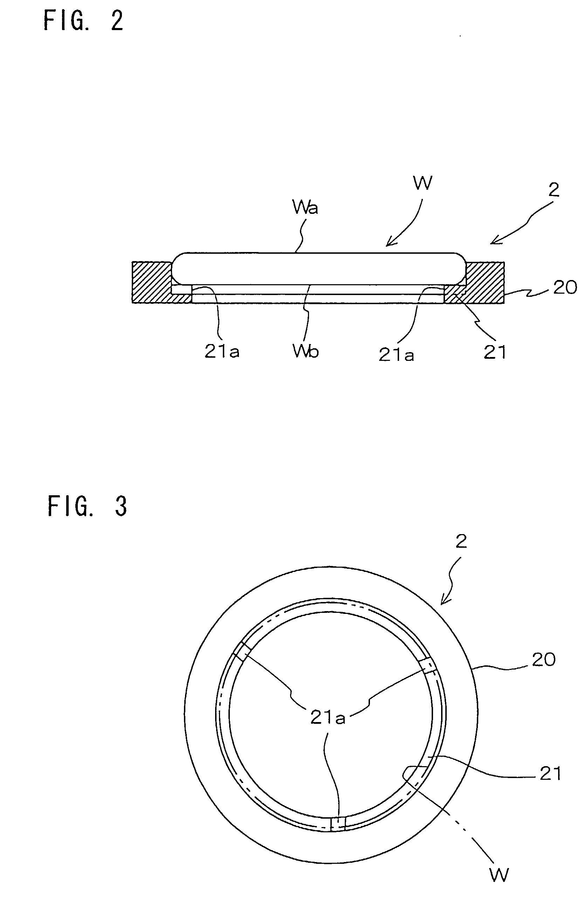

Fig. 2 is a vertical sectional view of the chuck 2 and Fig. 3 is a plan view thereof.

As shown in both figures, the chuck 2 has a ring-like outer wall portion 20 for supporting an outer edge of the silicon wafer W and a lower wall portion 21 for supporting the silicon wafer W from below. Three lugs 21a of a predetermined height are projected from an upper surface of the lower wall portion 21.

The silicon wafer W, with a surface Wa thereof facing upward, is put on the three lugs 21a inside the outer wall portion 20 and is thereafter attracted electrostatically by the chuck 2. In this state, the whole of the surface Wa of the silicon wafer W and the greater part of a back Wb of the wafer are exposed.

The plasma generator 3 shown in Fig. 1 has a discharge tube 30, a microwave oscillator 31, and a waveguide 32. An active species gas formed within the discharge tube 30 is injected from a nozzle portion 30a.

The discharge tube 30 is made of quartz or alumina and with the nozzle portion 30a being formed at a lower end portion thereof. A feed pipe 54 is connected to an upper end portion of the discharge tube 30, and etching gas and oxygen gas are fed to the discharge tube 30 from the local etching gas feeder 4 and the oxygen gas feeder 5, respectively, which are connected to the feed pipe 54. The nozzle portion 30a is inserted into the chamber 1 through a hole 10a formed centrally of an upper surface of the chamber 1. An O-ring 11 is inserted between the hole 10a and the nozzle portion 30a to provide a seal. A duct 12 is disposed around the nozzle portion 30a. A vacuum pump 13 discharges etching-produced reaction gas to the exterior of the chamber 1 through the duct 12.

The microwave oscillator 31, more specifically a magnetron, can generate a microwave M of a predetermined frequency.

The waveguide 32 propagates the microwave M generated by the microwave oscillator 31. A hole 33 is formed in the waveguide 32 and the discharge tube 30 is inserted into the hole 33. A reflection plate (short plunger) 34 for reflecting the microwave M to form a standing wave is attached to the interior of the left-hand end of the waveguide 32. At intermediate positions of the waveguide 32 are mounted three stub tuners 35 for impedance matching and an isolator 36 for bending the reflected microwave M in a 90° direction (in the surface direction in Fig. 1) which microwave is advancing toward the microwave oscillator 31.

The etching gas feeder 4 is provided with a gas cylinder 40, a flow controller 41, and a valve 42. A local etching gas (sulfur hexafluoride, SF₆; tetrafluoromethane, CF₄; or hexafluoroethane, C₂F₆) contained in the gas cylinder 40 is allowed to flow through the valve 42 and the flow controller 41 to the feed pipe 54. The gas is then fed from the feed pipe 54 into the discharge tube 30 of the plasma generator 3 and is plasma-excited within the discharge tube 30, whereby there is formed an active fluorine species gas.

On the other hand, the oxygen gas feeder 5 is provided with a gas cylinder 50 which contains oxygen gas, a flow controller 51, and a valve 52. The oxygen gas contained in the gas cylinder 50 is allowed to flow through the valve 52 and the flow controller 51 to the feed pipe 54 and is then fed from the feed pipe 54 into the discharge tube 30 of the plasma generator 3. Within the discharge tube 30 the oxygen gas is plasma-excited to produce an active oxygen species gas.

In the first step the valve 41 is opened and a local etching for the silicon wafer W is performed with the active fluorine species gas produced within the discharge tube 30. In the next step the valve 41 is closed, then the valve 51 is opened, a separated material deposited on the silicon wafer is removed with the active oxygen species gas produced and at the same time there is formed a thin layer of silicon oxide on the wafer surface.

The X-Y drive mechanism 6 moves the chuck 2 so that an opening 30b of the nozzle portion 30a moves relatively along the surface Wa of the wafer W. More specifically, the X-Y drive mechanism 6 is provided with an X drive motor 60 and a Y drive motor 61. The X drive motor 60 causes the chuck 2 to move in the right and left direction in Fig. 1, while the Y drive motor 61 causes the chuck 2 to move in the paper surface and back direction in the same figure. The X-Y drive mechanism 6 is connected to the chuck 2 through a chuck support 62.

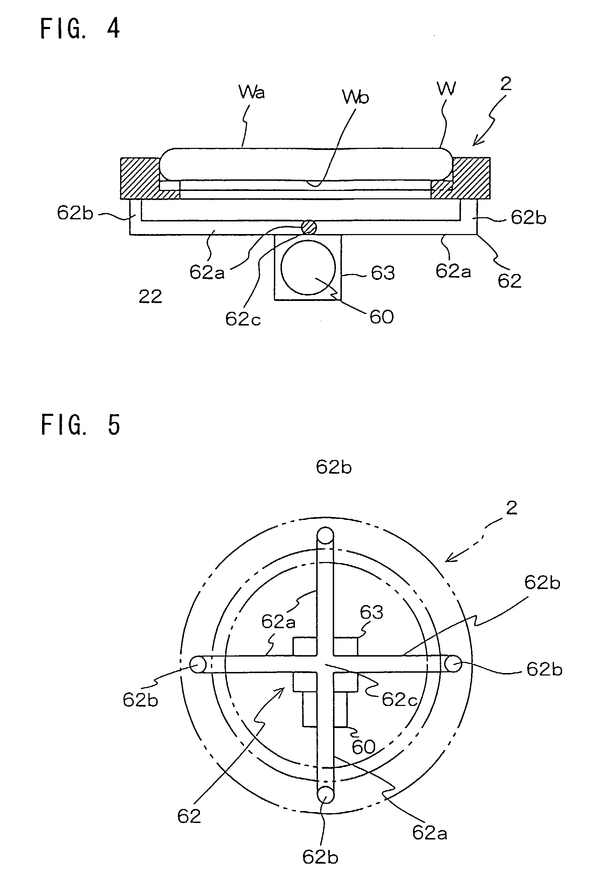

Fig. 4 is a vertical sectional view of the chuck support 62 and Fig. 5 is a plan view thereof.

The chuck support 62 has four arms 62a which are connected together in a crossed shape. Distal ends 62b of the arms 62a are bent upward and are bonded to a lower surface of the chuck 2. A connection 62c of the four arms 62a is connected to the X-Y drive mechanism 6. The gas present within the chamber 1 can pass freely between adjacent arms 62a of the chuck support 62 and therefore substantially the whole of the back Wb of the silicon wafer W comes into contact with the gas in the chamber 1.

In Fig. 1, the Z drive mechanism 7 is provided with a Z drive motor 70, whereby the whole of the X-Y drive mechanism 6, and hence the chuck 2, is moved vertically, causing the surface Wa of the silicon wafer W to move toward or away from the opening 30b of the nozzle portion 30a.

The X drive motor 60 and Y drive motor 61 of the X-Y drive mechanism 6 and the Z drive motor 70 of the Z drive mechanism 7 are controlled by a control computer 67.

The following description is now provided about a planarizing treatment and post treatment for the silicon wafer W with use of the planarizing system of this embodiment.

Reference will first be made to a local etching process which is a planarizing process. With the silicon wafer W chucked by the chuck 2, the vacuum pump 10 is operated to reduce the internal pressure of the chamber 1. The Z drive mechanism 7 is operated and the whole of the X-Y drive mechanism 6 is raised, with the result that the silicon wafer W approaches the opening 30b of the discharge tube 30.

In this state, the valve 42 of the local etching gas feeder 4 is opened and sulfur hexafluoride (SF₆) gas contained in the gas cylinder 40 is fed into the discharge tube 30 through the flow controller 41 and feed pipe 54. At this time, the pressure of SF₆ gas is maintained at a predetermined level by adjusting the degree of opening of the valve 42 appropriately. The flow rate of SF₆ gas is adjusted by the flow controller 41.

The microwave oscillator 31 is operated concurrently with the feed of SF₆ gas. The SF₆ gas present in the discharge site is plasma-excited to produce an active fluorine species gas G. The gas G is conducted to the nozzle portion 30a and is injected toward the surface Wa of the silicon wafer W from the opening 30b of the nozzle portion.

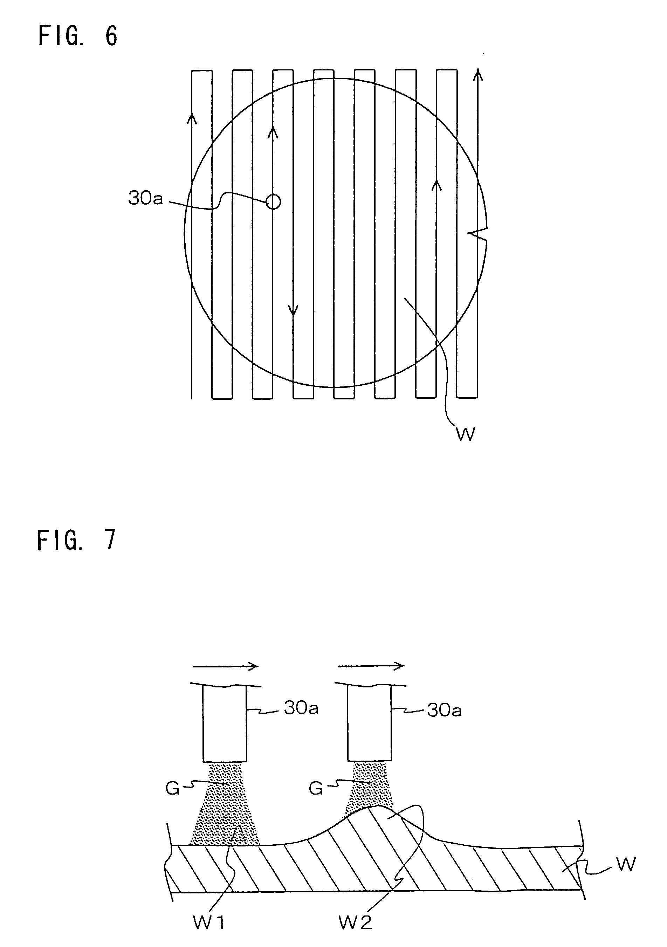

Concurrently with the injection of the active fluorine species gas G the control computer 67 causes the X-Y drive mechanism 6 to operate, thereby causing the chuck 2 with the silicon wafer W chucked thereon to move relatively in X-Y direction in a zigzag fashion. The path of this zigzag relative movement, or scanning, is shown in Fig. 6. The surface Wa of the silicon wafer W is flattened by controlling the speed of the said relative movement.

Fig. 7 is a schematic diagram which explains the principle for flattening the surface Wa of the silicon wafer W. The speed of the relative movement is controlled in the following manner. The active fluorine species gas G injected to the wafer surface Wa exhibits the highest material removal ability at a position right beneath the opening 30b, which ability is deteriorated gradually as the distance from the center increases. The longer the injection time of the gas G to the wafer surface Wa, the larger the amount of material removed at the gas-ejected portion. Thus, the amount of material removed at the gas-ejected portion increases when the relative speed between the wafer surface Wa and the nozzle portion 30a is low, while it decreases when the relative speed is high.

In the local etching apparatus, as shown in Fig. 7, for a relatively thick portion W2 of the silicon wafer there is made control so that the nozzle portion 30a moves at a low speed, while for a relatively thin portion W1 there is made control so that the nozzle portion 30a moves at a high speed. Appropriate moving speeds of the nozzle portion are determined on the basis of a surface uneven shape of the silicon wafer W measured in advance. As a result, the material of the relatively thick portion W2 is removed in a larger quantity, whereby the surface Wa of the silicon wafer W is flattened.

In this etching process, a portion of the active fluorine species gas used undergoes a chemical change, with formation of sulfur, carbon, or a compound thereof. The product thus formed adheres to the surface of the silicon wafer and contaminates a cleaning vessel in a subsequent cleaning process or contaminates a cassette which is for receiving the silicon wafer therein.

Further, since the virgin surface of the silicon wafer W thus etched is activated very strongly, the silicon on the wafer surface easily undergoes a chemical reaction with impurities contained in air and therefore the wafer surface is contaminated easily.

In the present invention, the following surface treatment is performed for removing the aforesaid product adhered to the surface of the etched silicon wafer and for preventing easy contamination of the surface.

After the plasma generator 3 and local etching gas feeder 4 shown in Fig. 1 are turned OFF, the vacuum pump 10 is actuated, whereby the gas remaining in the chamber 1 is discharged to the exterior. Further, the Z drive mechanism 7 is operated, whereby the silicon wafer W is brought down away from the opening 30b of the discharge tube 30.

Thereafter, the valve 52 of the oxygen gas feeder 5 is opened and O₂ gas contained in the gas cylinder 50 is fed into the discharge tube 30 through the flow controller 51 and feed pipe 54. At this time, the pressure and flow rate of the O₂ gas are adjusted by the valve 52 and the flow controller 51, respectively.

The microwave oscillator 31 is again operated concurrently with the feed of O₂ gas. As a result, the O₂ gas present at the discharge site is plasma-excited by the microwave M. The plasma-excited gas, i.e., an active oxygen species gas G1, is conducted to the nozzle portion 30a and is discharged from the opening 30b of the nozzle portion 30a and spreads throughout the whole of the chamber 1. Since the active oxygen species gas G1 is extremely high in chemical activity, the sulfur, carbon, or compound thereof, produced in the preceding process and adhered to the surface of the silicon wafer is oxidized easily by the active oxygen species gas G1. By this reaction there is formed SO₂ or CO₂, which, because of gas, leaves the surface of the silicon wafer W rapidly. Thus, the adhered material can be removed completely by exposing the silicon wafer W to the active oxygen species gas G1 for about 10 to 300 seconds.

Further, the active oxygen species gas G1 and silicon easily undergo a chemical reaction with each other to form a thin layer of silicon oxide on the wafer surface, which silicon oxide layer protects the silicon wafer from contamination.

Thus, with a single surface treating apparatus according to this embodiment, it is possible to flatten the surface of the silicon wafer W, remove the substance adhered to the silicon wafer completely in such a short time as 10 to 300 seconds, and form a thin layer of silicon oxide for protecting the silicon wafer from contamination.

To demonstrate these effects, the present inventor conducted the following comparative experiment for eleven silicon wafers W (8 inches dia.).

First, all the silicon wafers W were subjected to a local etching treatment under the conditions of an intra-chamber 1 pressure of 2.0 Torr, a SF₆ gas feed rate of 300 SCCM (300 ml/min), and a microwave oscillator 31 output of 350 W.

Next, nine out of the thus locally etched silicon wafers W were exposed respectively for different periods of time to an atmosphere of the active oxygen species gas G1 under the conditions of an intra-chamber 1 pressure of 1.0 Torr, an O₂ gas feed rate of 200 SCCM, and a microwave oscillator 31 output of 120W. The first, second, third, fourth, fifth, sixth, seventh, eighth, and ninth silicon wafers W were exposed to the atmosphere of active oxygen species gas G1 for only 1 second, 2 seconds, 3 seconds, 5 seconds, 15 seconds, 30 seconds, 1 minute, 2 minutes, and 5 minutes, respectively.

The remaining two silicon wafers W were subjected to a wet cleaning without being exposed to the gas G1 atmosphere. To be more specific, the tenth silicon wafer W was subjected to cleaning with pure water for 3 minutes and the eleventh silicon wafer W was subjected to cleaning with a liquid mixture of sulfuric acid and aqueous hydrogen peroxide at a ratio of 3:1 respectively.

As a result, there was recognized a contaminant residue on each of the first to third silicon wafers W, while no contaminant was recognized in each of the fourth to ninth silicon wafers W, i.e., the silicon wafers exposed to the active oxygen species gas G1 for 5 seconds to 5 minutes, respectively, thus indicating a nearly complete removal of contamination.

As to the tenth and eleventh silicon wafers W, there was recognized a residue of contaminant and thus the removal of contaminant was not successful.

From the above comparative experiment it is seen that a nearly perfect contaminant removal can be effected by exposing a locally etched silicon wafer W to the active oxygen species gas G1 for such a short period of 10 to 300 seconds.

### SECOND EMBODIMENT

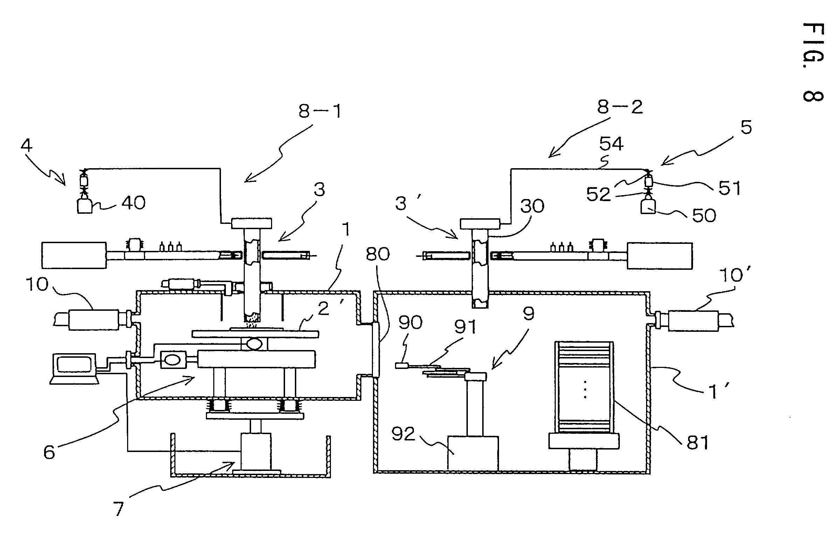

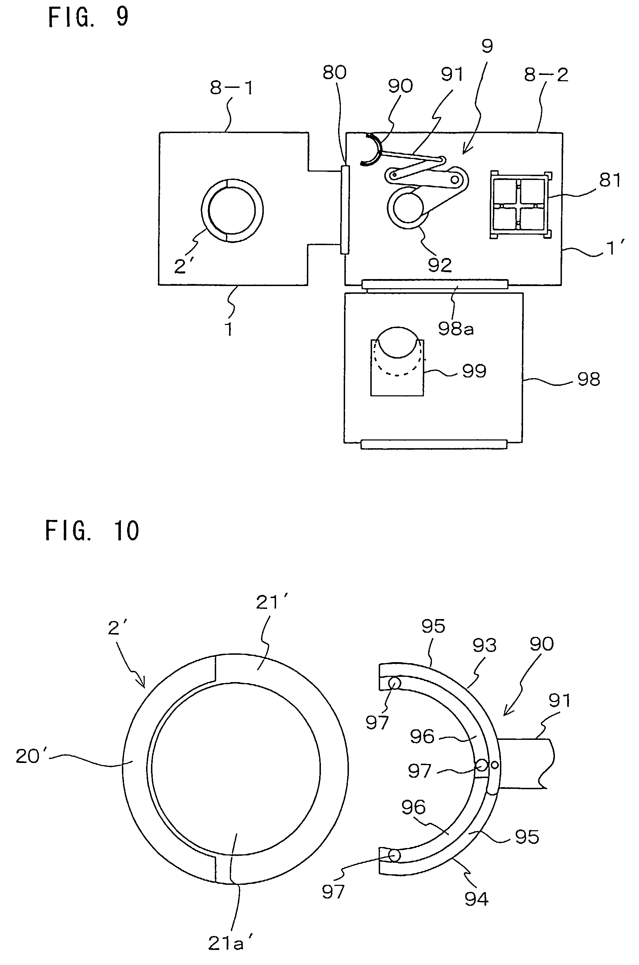

Fig. 8 is a sectional view showing a planarizing system according to the second embodiment of the present invention and Fig. 9 is a schematic plan view thereof.

As shown in these figures, the planarizing system is provided with a local etching apparatus 8-1, an active oxygen species atmosphere forming apparatus 8-2, and a conveying apparatus 9.

The local etching apparatus 8-1 is provided with a chamber 1, a chuck 2', a plasma generator 3, a local etching gas feeder 4, an X-Y drive mechanism 6, and a Z drive mechanism 7. The structure of the local etching apparatus 8-1 is almost the same as that of the planarizing system of the first embodiment. However, since the local etching apparatus 8-1 is intended to perform only local etching for a silicon wafer W, it is not provided with the oxygen gas feeder 5, nor is provided with such a structure as connects the chuck 2 and X-Y drive mechanism 6 through the chuck support 62.

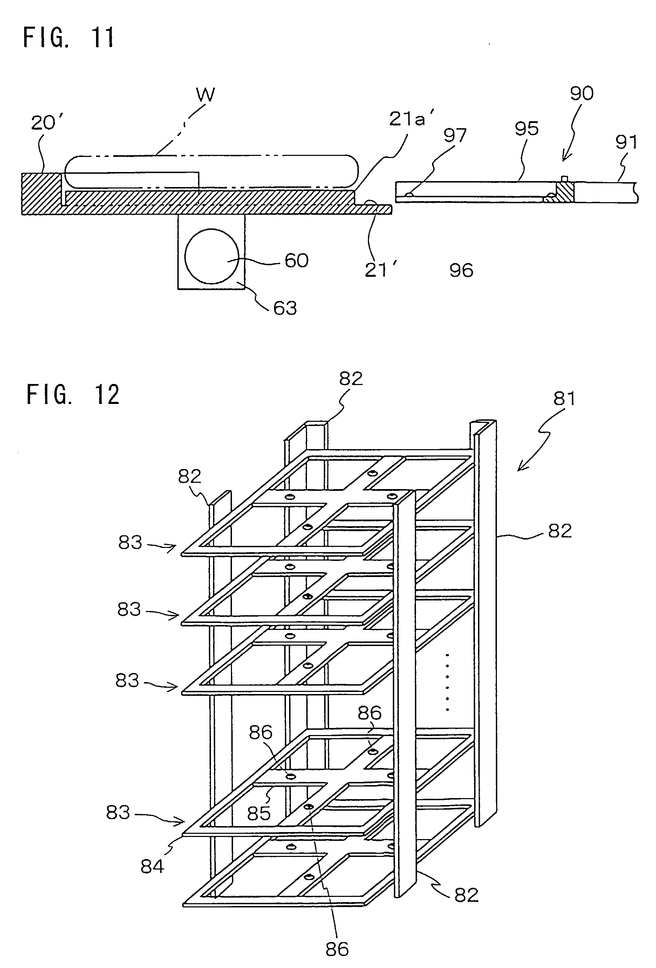

Fig. 10 is a plan view showing the structure of the chuck 2' used in the second embodiment and Fig. 11 is a sectional view thereof.

The chuck 2' is provided with a disc-like lower wall portion 21', a central disc-like protuberance 21a' which is a little smaller than the silicon wafer W, and an arcuate outer wall portion 20' at a left side portion on the lower wall portion 21'. As shown in Fig. 11, a central part of a lower surface of the lower wall portion 21' is connected directly to a mechanical portion 63 of the Y-Y drive mechanism 6.

A back Wb of the silicon wafer W is attracted electrostatically by the protuberance 21a' and the wafer W is moved horizontally and vertically by the X-Y drive mechanism 6 and the Z drive mechanism 7.

As shown in Figs. 8 and 9, the local etching apparatus 8-1 and the active oxygen species atmosphere forming apparatus 8-2 are connected together through a gate valve 80 which is capable of opening and closing. Through the gate valve 80 the silicon wafer W can be conveyed from the local etching apparatus 8-1 to the active oxygen species atmosphere forming apparatus 8-2 or vise versa. By closing the gate valve 80, the gas present in the local etching apparatus 8-1 and the gas in the active oxygen species atmosphere forming apparatus 8-2 are cut off each other.

A vacuum pump 10' is provided in a chamber 1' of the active oxygen species atmosphere forming apparatus 8-2, whereby the interior of the chamber 1' can be made substantially vacuous. On an upper side of the chamber 1' is provided a plasma generator 3' whose structure is substantially the same as that of the plasma generator 3 in the local etching apparatus 8-1. A discharge tube 30 of the plasma generator 3' is mounted to an upper surface of the chamber 1' and an opening 30b of the nozzle portion 30a is in communication with the interior of the chamber 1'.

Since the active oxygen species atmosphere forming apparatus 8-2 is for making the interior of the chamber 1' into an atmosphere of an active oxygen species gas G1, only an oxygen gas feeder 5 is connected to the plasma generator 3'. More specifically, an oxygen gas cylinder 50 is connected to a feed pipe 54 through a flow controller 51 and a pump 52, and the feed pipe 54 is connected to an upper end portion of the discharge pipe 30 in the plasma generator 3'.

Within the chamber 1' of the active oxygen species atmosphere forming apparatus 8-2 is disposed a wafer cassette 81. Fig. 12 is a perspective view showing the wafer cassette 81.

The wafer cassette 81 has multi-stage, say, 25-stage, receptacle portions 83 which are supported by four supporting posts 82 and which can each receive the silicon wafer W therein.

Each receptacle portion 83 has a frame 84 to which is bonded a crossed plate 85, with lugs 86 being formed on the plate 85 to put the back Wb of the silicon wafer W thereon. When the silicon wafer W is put on the four lugs 86 of the receptacle portion 83, the four lugs 86 and the wafer back Wb come into dot-like contact with each other, so that the greater part of the surface Wa of the silicon wafer W and the greater part of the back Wb of the wafer are exposed to the gas (active oxygen species gas) present in the chamber 1'.

Within the chamber 1' is disposed a robot 9 as conveying means, which conveys the silicon wafer W after local etching to each receptacle portion 83 in the wafer cassette 81. The robot 9 is provided with plural arms 91 with a hand 90 attached thereto and a drive unit 92 for moving the arms and the hand 90. The hand 90 has a pair of pawls 93 and 94 which are capable of opening and closing. The pawls 93 and 94 are formed with grip portions 95, respectively, which assume a generally semicircular shape when closed and whose inside diameter is almost equal to the diameter of the silicon wafer W. Along inside lower portions of the grip portions 95 are formed support portions 96 for supporting the silicon wafer W from below when the wafer is gripped. On the support portions 96 are formed lugs 97 for putting the wafer W thereon.

Within a loading/unloading chamber 98 (Fig. 9) is placed a cassette 99 containing untreated silicon wafers W. The robot 9 conveys the silicon wafers W one by one from the interior of the cassette 99 into the local etching apparatus 8-1 and also conveys a wafer cassette 81 containing untreated twenty-five silicon wafers W into the loading/unloading chamber 98.

A description will now be given of the operation of this embodiment. First, in the local etching apparatus 8-1 there is performed the same etching treatment as in the first embodiment. That is, the silicon wafer W on the chuck 2' is subjected to local etching with an active fluorine species gas G which has been produced by microwave-activating SF₆ gas.

When the local etching is over, the interior of the chamber 1 is made substantially vacuous by means of the vacuum pump 10, thereafter the arms 91 of the robot 9 which is controlled by the drive unit 92 advance into the chamber 1 of the local etching apparatus 8-1, and the silicon wafer W is taken out from the chuck 2' by the hand 90.

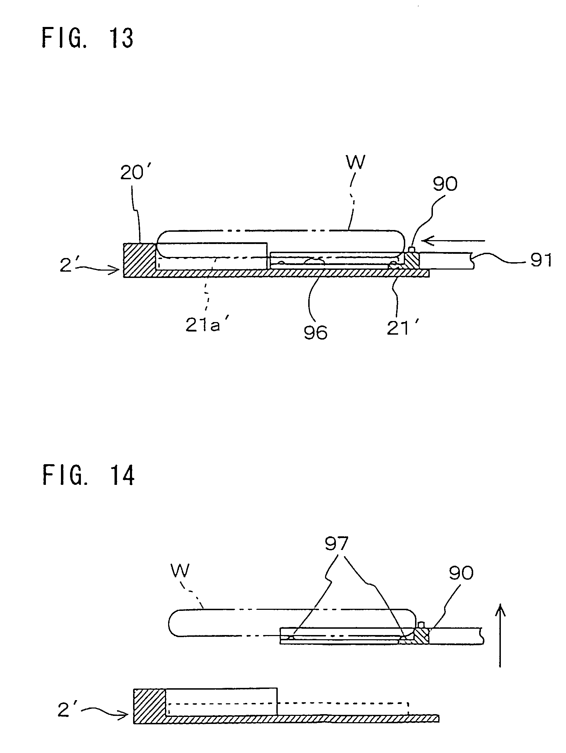

More particularly, in a somewhat opened state of the pawls 93 and 94 of the hand 90 shown in Fig. 10, the support portions 96 of the pawls 93 and 94 are put on the lower wall portion 21' of the chuck 2' are advanced below the silicon wafer W, as shown in Fig. 13. Then, the whole of the hand 90 is raised just before abutment of the tip ends of the pawls 93 and 94 against the outerwall portion 20', whereby the silicon wafer W as rested on the lugs 97 is taken out from the chuck 2', as shown in Fig. 14.

Subsequently, the robot 9 conveys the silicon wafer W thus taken out into the chamber 1' of the active oxygen species atmosphere forming apparatus 8-2 and further into the first-stage receptacle portion 83 in the wafer cassette 81 shown in Fig. 12.

To be more specific, the hand 90 is moved up to a position just above the receptacle portion 83 and the pawls 93 and 94 are opened, allowing the silicon wafer W to drop slowly onto the lugs 86 in the receptacle portion 83 and thereby placing the wafer within the receptacle portion.

After the silicon wafer W having been subjected to local etching is accommodated in the receptacle portion 83, the robot 9 takes out an untreated silicon wafer W from the cassette 99 through a gate valve 98a in the loading/unloading chamber 98, conveys it into the local etching apparatus 8-1, then brings the arms back into the active oxygen species atmosphere forming apparatus 8-2, and stands by.

In this state, the gate valve 80 in the active oxygen species atmosphere forming apparatus 8-2 and the gate valve 98a in the loading/unloading chamber 98 are closed and the local etching is performed for the second silicon wafer W.

Concurrently with the local etching there is formed an active oxygen species atmosphere within the active oxygen species atmosphere forming apparatus 8-2. More specifically, oxygen gas is fed from the gas cylinder 50 of the oxygen gas feeder 5 into the discharge tube 30 of the plasma generator 3' through the flow controller 51, valve 52 and feed pipe 54 and an active oxygen species gas G1 resulting from discharge by the microwave generator 31 is injected into the chamber 1' from the opening 30b of the nozzle portion 30a and is filled within the chamber 1'. As a result, substantially the whole surface of the silicon wafer W received in the first-stage receptacle portion of the wafer cassette 81 is exposed to the active oxygen species gas G1.

When the local etching for the second silicon wafer W is completed in the local etching apparatus 8-1, the interior of the chamber 1 of the local etching apparatus 8-1 and the interior of the active oxygen species forming apparatus 8-2 are made substantially vacuous, then the gate valve 80 is opened and the second silicon wafer W is received in the second-stage receptacle portion 83 in the wafer cassette 81.

Subsequently, the above local etching for each silicon wafer and the above exposure of the locally etched silicon wafer to an active oxygen species atmosphere are carried out in a substantially parallel manner for the third to the twenty-fifth silicon wafer W.

After the last (twenty-fifth) silicon wafer has been received in the twenty-fifth stage of receptacle portion 83, the active oxygen species atmosphere is maintained for 10 to 300 seconds, whereby all the silicon wafers W, including the twenty-fifth wafer, are exposed to the active oxygen species atmosphere for a sufficient time for contaminant removal.

Thus, according to this second embodiment, the local etching and the contaminant removal are conducted in separate apparatuses, so there is attained an extremely high throughput in comparison with the first embodiment.

### THIRD EMBODIMENT

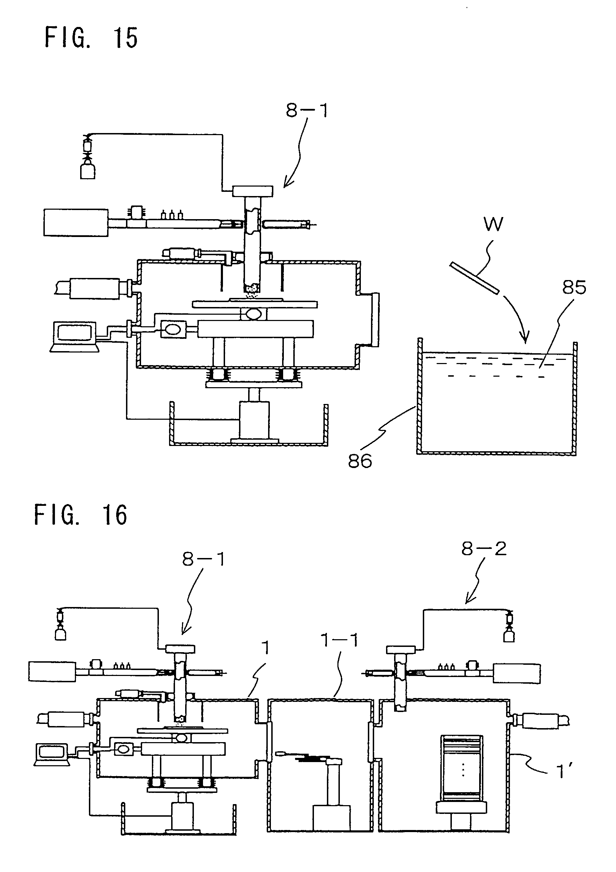

Fig. 15 is a diagram explanatory of a surface treatment method for a silicon wafer according to the third embodiment of the present invention.

As shown in Fig. 15, a planarizing system according to this embodiment is provided with the local etching apparatus 8-1 used in the previous second embodiment and a vessel 86 containing a hydrofluoric acid solution 85.

In this embodiment, a silicon wafer W having been treated in the local etching apparatus 8-1 is dipped in a hydrofluoric acid solution for a predetermined time or longer, say 1 minutes or longer, whereby materials deposited on the silicon wafer, especially a sulfur compound, can be removed easily.

A further explanation will be omitted because the other constructional points than the dipping of the silicon wafer W in the hydrofluoric acid solution 85, as well as function and effect, are the same as in the above second embodiment.

The present invention is not limited to the above embodiments, but various modifications and changes may be made within the gist of the present invention.

Although the plasma generator 3 which utilizes a microwave is used in the above three embodiments, any other plasma generator may be used insofar as it can produce an active fluorine species gas or an active oxygen species gas.

Although sulfur hexafluoride (SF₆) gas is used as a gas for the local etching, no limitation is made thereto. Any fluoride gas may be used, e.g., tetrafluoromethane (CF₄) gas or hexafluoroethane (C₂F₆) gas.

Although in the above first and second embodiments a pure oxygen gas is used as a surface treating gas, there may be used a gaseous mixture of oxygen gas with another gas.

Although in the above second embodiment the lugs 97 are formed on the hand 90 of the robot 9, the lugs 97 are not always needed. There may be adopted a structure wherein the silicon wafer W is put on the support portions 96 directly.

Although in the above second embodiment the discharge tube 30 of the plasma generator 3' in the active oxygen species atmosphere forming apparatus 8-2 is mounted to the upper surface of the chamber 1' , the discharge tube 30 may be mounted in any position insofar as the opening 30b of the nozzle portion 30a is in communication with the chamber 1' because all that is required is to make the interior of the chamber 1' into an atmosphere of the inert oxygen species gas G1.

Although in the above second embodiment the robot 9 is disposed within the chamber 1' of the active oxygen species atmosphere forming apparatus 8-2, there may be adopted such a construction as shown in Fig. 16 wherein another chamber 1-1 is provided between the local etching apparatus 8-1 and the active oxygen species atmosphere forming apparatus 8-2 and the robot 9 is disposed within the chamber 1-1.

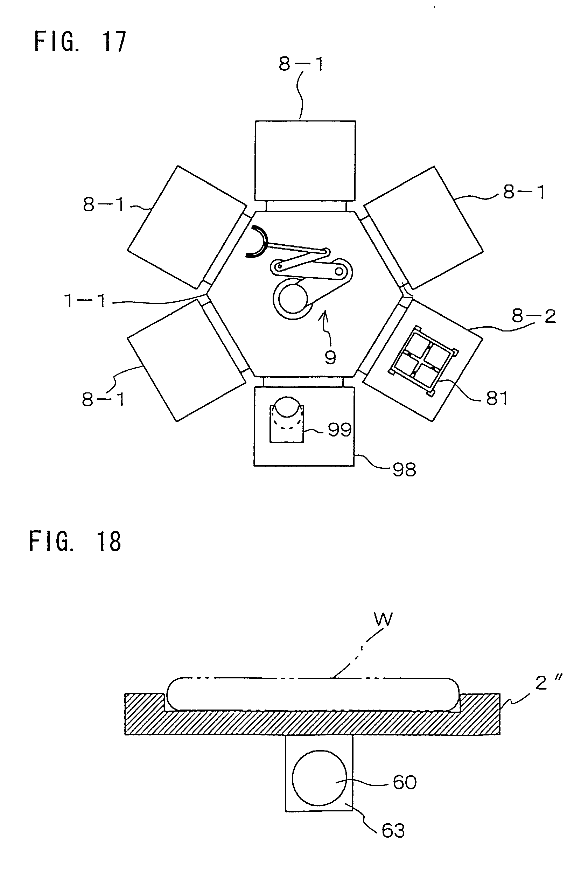

There also may be adopted such a construction as shown in Fig. 17 wherein plural local etching apparatuses 8-1, one (or plural) active oxygen species atmosphere forming apparatus 8-2, and one (or plural) loading/unloading chamber 98 are disposed around a polygonal chamber 1-1 and a silicon wafer W is conveyed to or from each apparatus by means of a robot 9 disposed within the chamber 1-1. According to this construction there can be attained a further improvement of throughput.

Although in the above third embodiment the hydrofluoric acid solution 85 is used for removing the contaminant deposited on the silicon wafer surface or for forming a thin layer of silicon oxide on the wafer surface, ozone water may be used instead of the hydrofluoric acid solution.

Further, although the chuck 2 having a hole 22 for holding the silicon wafer W is used in the above first embodiment, the chuck 2 may be substituted by such a disc-like chuck 2" not having any hole as shown in Fig. 18.

According to the present invention, as will be apparent from the above embodiments, sulfur, carbon, or a compound thereof, which is produced by local etching for flattening the silicon wafer surface and which has adhered to the wafer surface, is removed from the wafer surface. Besides, a thin layer of silicon oxide is formed on the wafer surface to prevent the silicon wafer from being newly contaminated by impurities present in air.

## Claims

1. A surface treatment method for a silicon wafer comprising the following steps of:
etching a silicon wafer by injecting a plasma-excited active fluorine species gas of fluoride on the surface thereof; and
removing separated material absorbed on the surface of said silicon wafer in said etching step by exposing said silicon wafer to a plasma-excited active oxygen species gas, said separated material being separated from said plasma-excited active fluorine species gas.

2. A surface treatment method for a silicon wafer according to claim 1, wherein saidplasma-excitedactive fluorine species gas contains sulfur or carbon and said absorbed material is a simple substance or a compound of sulfur or carbon.

3. A surface treatment method for a silicon wafer according to claim 1, wherein said plasma-excited active fluorine species gas is injected through a nozzle.

4. A surface treatment method for a silicon wafer comprising the following steps of:
etching a silicon wafer by injecting a plasma-excited active fluorine species gas of fluoride on the surface thereof; and
removing separated material absorbed on the surface of said silicon wafer in said etching step by dipping said silicon wafer into ozone water or hydrofluoric acid solution, said separated material being a simple substance or a compound of sulfur being separated from said plasma-excited active fluorine species gas.

5. A surface treatment method for a silicon wafer according to claim 4, wherein said fluorine compound gas is sulfur hexafluoride (SF₆).

6. A surface treatment method for a silicon wafer according to claim 4, wherein said plasma-excited active fluorine species gas is injected through a nozzle.
